# DEMANDE DE BREVET EUROPEEN

(11) **EP 0 849 792 A1**
(43) Date de publication de la demande: **24.06.1998**
(21) Numéro de dépôt: 97410147.9
(22) Date de dépôt: 19.12.1997
(51) Int. Cl.: H01L 21/8249, H01L 27/06

(54) **Procédé BiCMOS avec capacité**

(30) Priorité: 20.12.1996 FR 9616065
(71) Demandeur: SGS-THOMSON MICROELECTRONICS S.A., 94250 Gentilly (FR)
(72) Inventeur: Gris, Yvon, 38210 Tullins (FR)
(74) Mandataire: de Beaumont, Michel

(57) **Abrégé**

L'invention concerne un procédé de fabrication d'un condensateur dans une technologie de fabrication de circuit intégré BICMOS comprenant les étapes consistant à déposer, sur une région d'oxyde épais (5), une couche de silicium polycristallin (113) correspondant à une électrode de grille de transistor MOS; déposer successivement une couche de silicium polycristallin de base (22) et une couche d'oxyde de silicium (23) ; former une ouverture (101) dans ces deux dernières couches ; procéder à un recuit thermique en atmosphère oxydante (131) ; déposer une couche de nitrure (144) et une couche de silicium polycristallin d'espaceur (143) ; déposer une couche de silicium polycristallin d'émetteur ; et prendre un contact avec la couche de silicium polycristallin de base et un contact avec la couche de silicium polycristallin d'émetteur.

## Description

La présente invention concerne une filière de fabrication de circuits intégrés susceptibles de contenir notamment des composants bipolaires et MOS complémentaires (CMOS). Ce type de filière est habituellement appelé filière BICMOS.

Un objet de la présente invention est de prévoir une telle filière dans laquelle les dimensions d'un élément dessiné sur un masque peuvent être d'une dimension inférieure ou égale à 0,4 µm, par exemple 0,2 à 0,35 µm.

Un objet plus particulier de la présente invention est de prévoir une telle filière dans laquelle on forme aussi des capacités de forte valeur.

Pour atteindre ces objets, la présente invention prévoit un procédé de fabrication d'un condensateur dans une technologie de fabrication de circuit intégré BICMOS comprenant les étapes suivantes :
déposer, sur une région d'oxyde épais, une couche de silicium polycristallin correspondant à une électrode de grille de transistor MOS,
déposer successivement une couche de silicium polycristallin de base et une couche d'oxyde de silicium,
former une ouverture dans ces deux dernières couches,
procéder à un recuit thermique en atmosphère oxydante, pour former une couche d'oxyde,
déposer une couche de nitrure de silicium et une couche de silicium polycristallin d'espaceur, la largeur de l'ouverture étant suffisamment faible pour que, après gravure, le silicium polycristallin d'espaceur remplisse complètement l'ouverture,
déposer une couche de silicium polycristallin d'émetteur, et
prendre un contact avec la couche de silicium polycristallin de base et un contact avec la couche de silicium polycristallin d'émetteur.

Selon un mode de réalisation de la présente invention, la couche d'oxyde thermique a une épaisseur de l'ordre de 10 nm.

Selon un mode de réalisation de la présente invention, la couche de nitrure de silicium a une épaisseur de l'ordre de 30 nm.

Selon un mode de réalisation de la présente invention, les couches de silicium polycristallin de grille et de base sont dopées de type P et les couches de silicium polycristallin d'espaceur et d'émetteur sont dopées de type N.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 11 sont des vues en coupe schématique illustrant des étapes successives de fabrication d'un mode de réalisation d'un transistor MOS à canal N, d'un transistor MOS à canal P et d'un transistor bipolaire de type NPN ;
la figure 12 est une vue agrandie d'un transistor bipolaire de type NPN obtenu par le procédé illustré en figures 1 à 11 ; et
les figures 13 à 19 représentent des étapes de fabrication d'un condensateur selon la présente invention.

Comme cela est usuel dans le domaine de la représentation des composants semiconducteurs, les diverses vues en coupe ne sont pas tracées à l'échelle. Les dimensions latérales et transversales des diverses couches et régions sont arbitrairement dilatées ou rétrécies pour faciliter le tracé des figures.

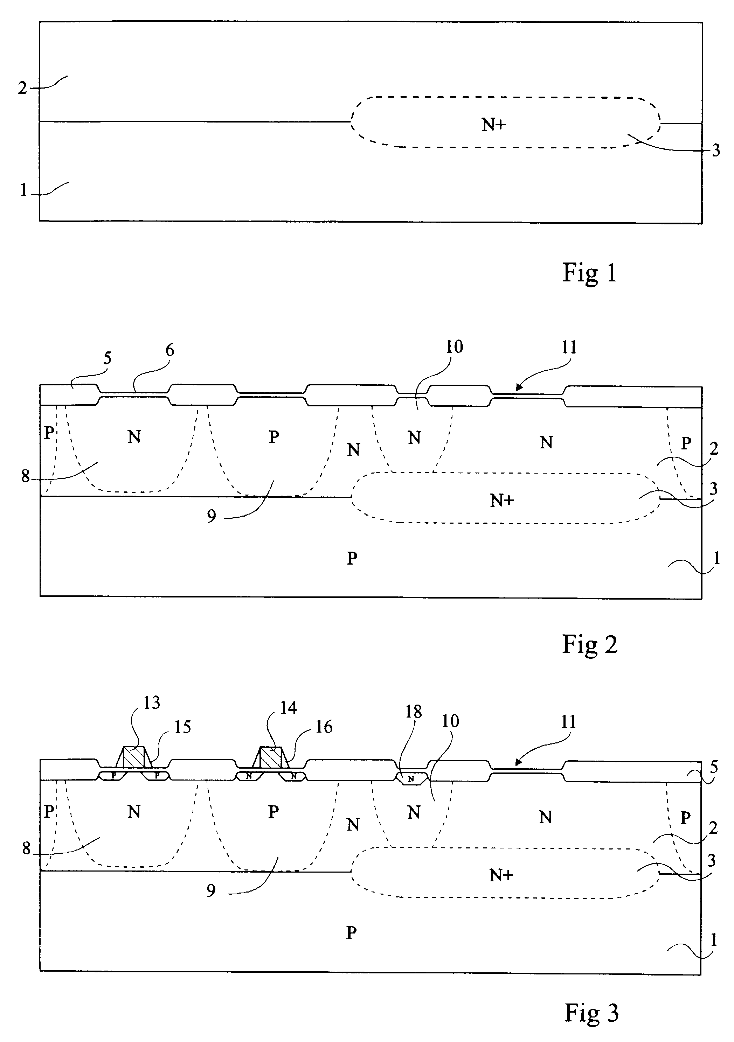

De façon générale dans la suite de la description, on désignera le côté gauche des figures 1 à 11 dans lequel est formé un composant CMOS par l'appellation côté MOS et le côté droit de ces figures dans lequel est formé un transistor bipolaire de type NPN par l'appellation côté bipolaire. Dans ce qui suit, on décrit la fabrication d'un transistor MOS à canal N, d'un transistor MOS à canal P et d'un transistor bipolaire de type NPN. Bien entendu, dans une réalisation pratique, on formera simultanément de nombreux composants identiques, ainsi qu'éventuellement d'autres types de composants élémentaires.

Selon un aspect de la présente invention, les étapes initiales correspondent à des étapes connues de fabrication de circuits intégrés CMOS de très petites dimensions (dimension minimum, ou dimension de grille, inférieure à 0,35 µm).

Comme le représente la figure 1, on part d'un substrat 1 de type P sur lequel est formée une couche épitaxiale 2 de type N. Cette couche épitaxiale est relativement mince, par exemple d'une épaisseur de l'ordre de 1 à 1,2 µm.

Avant la croissance de la couche épitaxiale, on prévoit si on le souhaite des couches enterrées de types appropriés dans les zones où doivent être formés des caissons N ou P de transistors CMOS et l'on forme une couche enterrée 3 de type N⁺ du côté bipolaire.

Comme le représente la figure 2, du côté MOS, on délimite les régions des transistors MOS par des ouvertures dans une couche d'oxyde épais 5 formée par toute technique connue. On implante, à travers l'oxyde épais ou une région d'oxyde mince 6 formée dans les ouvertures, des caissons 8 de type N et des caissons 9 de type P, de façon classique. Ces caissons sont par exemple formés par une succession de trois implantations dont l'une traverse l'oxyde épais 5 dans des régions non-masquées. Ces caissons N et P sont destinés respectivement à des transistors MOS à canal P et à des transistors MOS à canal N. Le niveau de dopage en surface (quelques 10¹⁶ at./cm³) détermine la tension de seuil des transistors. Dans le cas général, les caissons P (associés à une couche enterrée P⁺) sont en contact électrique avec le substrat P. On pourra toutefois prévoir de former certains au moins des caissons P sur une couche enterrée de type N. Les caissons N sont complètement isolés puisqu'ils débouchent dans le substrat P et ils sont isolés latéralement par des régions P formées comme les caissons P.

Simultanément, côté bipolaire, on délimite dans l'oxyde épais 5 une région dans laquelle sera formée une diffusion profonde de reprise de contact de collecteur ou puits collecteur 10 rejoignant la couche enterrée 3. Ce puits collecteur est formé par au moins certaines des implantations réalisées pour former le caisson 8 de type N, ou bien par une implantation spécifique de type N⁺. Ce puits collecteur peut aussi être formé ultérieurement en même temps que les sources et drains des transistors MOS à canal N. Egalement, on délimite dans l'oxyde épais une zone 11 dans laquelle seront formés la base et l'émetteur d'un transistor bipolaire de type NPN. Pendant les diverses implantations de caissons N et P, cette zone 11 est masquée.

Comme le représente la figure 3, du côté MOS, on forme de façon classique des grilles isolées 13 et 14 des transistors MOS ; on réalise des premières implantations (LDD) ; on forme des espaceurs 15 et 16 ; et on réalise des implantations de drains et de sources. Dans le caisson 8, les implantations sont de type P et, dans le caisson 9, les implantations sont de type N. En même temps que l'on fait les implantations de sources et de drains des transistors à canal N dans les caissons P, on réalise une diffusion de type N fortement dopée 18 à la surface du puits collecteur 10 pour améliorer la prise de contact ultérieure.

On effectue ensuite un recuit thermique rapide (1025°C).

Après cette étape, à la fin de laquelle l'essentiel des transistors MOS a été réalisé (sauf les éventuelles siliciurations de prise de contact et les métallisations), on procède à la réalisation du transistor bipolaire de type NPN.

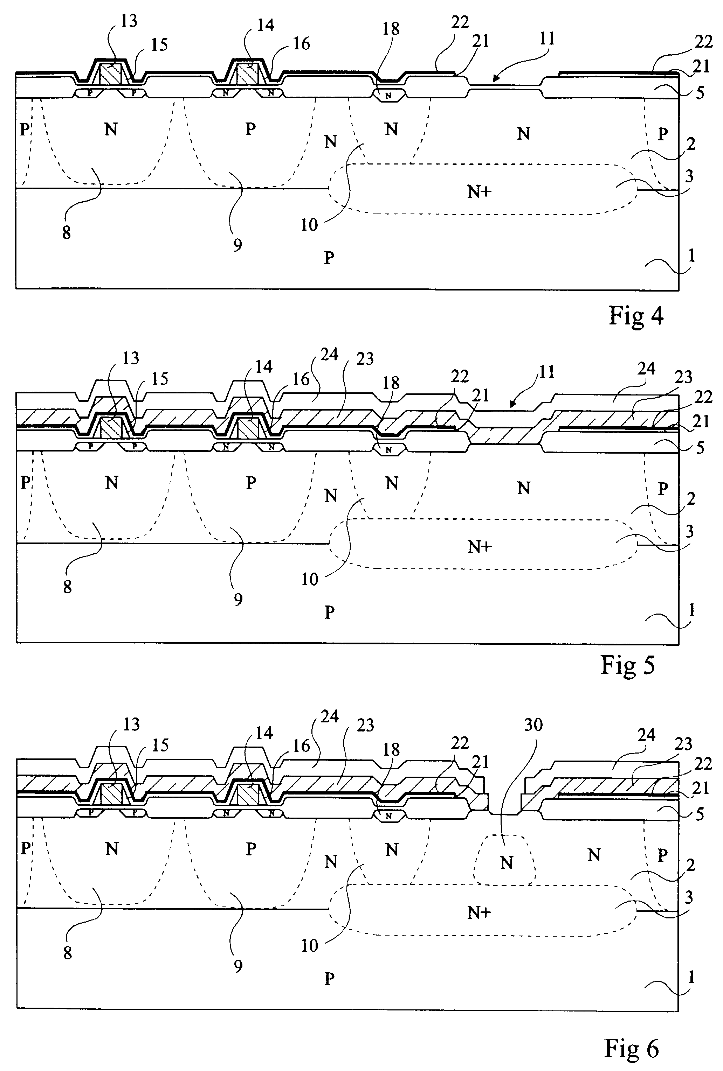

A l'étape illustrée en figure 4, on dépose sur l'ensemble de la structure, par voie chimique en phase vapeur, une double couche de protection comprenant une couche d'oxyde de silicium 21 ayant par exemple une épaisseur de l'ordre de 20 nm suivie d'une couche de nitrure de silicium 22 ayant par exemple une épaisseur de l'ordre de 30 nm. Cette couche 21-22 est ouverte dans la zone 11 où l'on souhaite former la région émetteur-base d'un transistor bipolaire. On notera que cette ouverture n'est pas critique puisqu'elle s'arrête sur des régions d'oxyde épais.

A l'étape illustrée en figure 5, on dépose sur l'ensemble de la structure une couche de silicium 23 ayant par exemple une épaisseur de l'ordre de 200 nm suivie d'une couche d'oxyde d'encapsulation 24 ayant par exemple une épaisseur de l'ordre de 300 nm.

La couche de silicium 23 doit être dopée de type P puisqu'elle servira comme on le verra ci-après de source de dopage pour la base extrinsèque du transistor NPN et sera appelée silicium polycristallin de base. Bien qu'elle soit désignée sous l'appellation silicium polycristallin, il pourra aussi s'agir de tout type de couche de silicium déposé, par exemple du silicium amorphe. De préférence, selon un aspect de la présente invention, on procède d'abord au dépôt d'une couche 23 de silicium polycristallin ou amorphe non dopé et l'on procède ensuite à une implantation d'un dopant de type P dans cette couche. De préférence, on implante du bore sous forme de BF₂ à très forte dose (10¹⁵ à 10¹⁶ at./cm²) et à faible énergie de sorte que le bore implanté se concentre dans la partie supérieure de la couche en évitant toute implantation de bore dans le substrat de silicium sous-jacent dans la région 11.

A l'étape illustrée en figure 6, on procède à une ouverture des couches 24 et 23 dans la partie centrale de la région 11. Cette ouverture a par exemple une largeur comprise entre 0,4 et 0,8 µm et pénètre dans le silicium monocristallin de moins de 50 nm. On procède ensuite à une implantation d'un dopant de type N pour définir le collecteur 30 du transistor NPN. Ce collecteur est donc auto-aligné sur l'ouverture. L'implantation N est réalisée à dose moyenne et forte énergie (par exemple, 10¹² à 10¹⁴ at./cm² sous 500 keV). On obtient ainsi une région effective de collecteur d'étendue latérale limitée, sensiblement égale à celle de la base intrinsèque qui est formée ensuite. Ceci contribue à l'obtention d'un transistor NPN de faible capacité parasite entre collecteur et base extrinsèque. L'implantation est optimisée (par exemple, par implantations successives) pour que le profil du collecteur fournisse le meilleur compromis possible entre, d'une part, la résistance de collecteur et le temps de transit dans ce collecteur et, d'autre part, l'obtention de tensions de claquage suffisamment élevées émetteur-collecteur (typiquement 4 volts) et base-collecteur et d'une faible capacité base-collecteur. On notera aussi que cette implantation de collecteur permet de choisir au préalable une couche épitaxiée 2 de dopage et d'épaisseur propres à optimiser les transistors CMOS et d'optimiser ensuite indépendamment les caractéristiques des transistors NPN. Notamment, cette couche épitaxiée pourra être plus épaisse que si elle devait servir directement de couche de collecteur du transistor NPN.

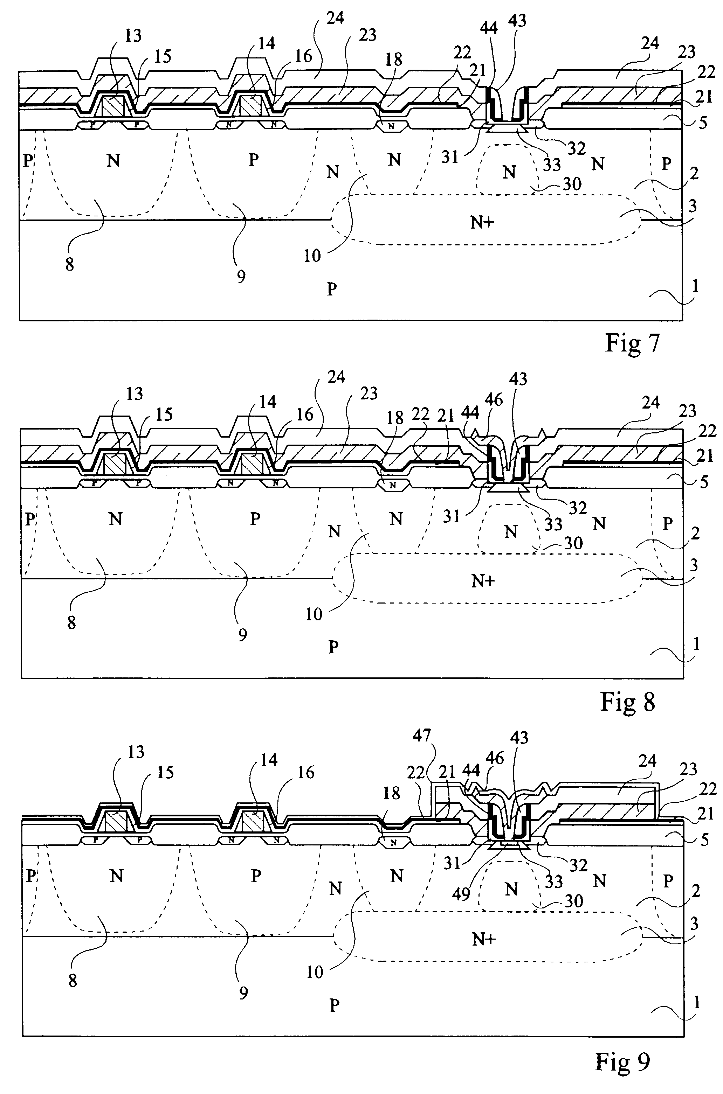

Comme le représente la figure 7, après élimination de la résine de masquage, on procède à une oxydation thermique pendant laquelle il se forme une mince couche d'oxyde thermique 31 d'une épaisseur de l'ordre de 5 à 10 nm et pendant laquelle le bore contenu dans la couche de silicium polycristallin 23 commence à diffuser dans la couche épitaxiée sous-jacente pour former une région de base extrinsèque 32 ayant par exemple une profondeur de jonction de l'ordre de 100 nm. Cette diffusion est ensuite complétée par le recuit final de la structure bipolaire. On procède alors à une implantation de type P à travers l'oxyde 31 pour former une région de base intrinsèque 33 au centre de l'ouverture dans les couches 23 et 24. Cette base intrinsèque est de préférence implantée au bore à faible énergie (par exemple, 10¹³ at./cm² sous 5 keV). Le contact avec le silicium polycristallin 23 résulte de la diffusion latérale du bore du silicium polycristallin.

On procède alors à un dépôt uniforme d'une couche mince de nitrure de silicium (30 nm) revêtue d'une couche de silicium polycristallin (100 nm). La couche de silicium polycristallin est ensuite gravée de façon anisotrope de façon qu'il n'en demeure que des espaceurs 43 sur les flancs de l'ouverture ménagée dans les couches 23 et 24. On procède ensuite à une gravure uniforme du nitrure de silicium, de sorte que ce nitrure de silicium reste en place seulement dans les régions 44 où il est protégé de la gravure (chimique ou plasma) par les espaceurs 43 de silicium polycristallin. L'ensemble du nitrure 44 et des espaceurs 43 définit donc une ouverture plus petite que l'ouverture initialement formée dans les couches 23 et 24 pour la définition de la base intrinsèque. Cette ouverture plus petite est l'ouverture d'émetteur. Si les espaceurs ont une largeur de l'ordre de 150 nm chacun, cette petite ouverture a une largeur de l'ordre de 0,5 µm.

A l'étape illustrée en figure 8, la couche mince d'oxyde 31 au fond de l'ouverture, qui avait servi de protection pendant l'implantation d'émetteur (bore) et d'arrêt de gravure de la couche de nitrure de silicium, est soigneusement nettoyée, par exemple dans un bain d'acide fluorhydrique dilué. On dépose une couche de silicium polycristallin fortement dopé de type N qui est ensuite gravée pour laisser en place une région 46. Des régions de la couche de silicium polycristallin dopé 46 peuvent être maintenues en place en des endroits choisis pour former par exemple des condensateurs entre des régions de ce silicium polycristallin 46 et des régions du silicium polycristallin de base 23.

A l'étape illustrée en figure 9, on élimine les couches d'oxyde 24 et de silicium polycristallin de base 23 en dehors de la région d'émetteur-base du transistor bipolaire et d'autres régions éventuelles comportant des dispositifs utilisant des portions de la couche de silicium polycristallin de base 23 (résistances, capacités...). Puis l'on dépose une couche d'oxyde de silicium d'encapsulation 47.

Après cela, on procède à un recuit de pénétration du dopant contenu dans la couche de silicium polycristallin 46 au centre de la région de base du transistor pour former son émetteur 49 de type N. Les recuits associés au transistor bipolaire assurent une réactivation électrique des dopants et conduisent à des profondeurs de jonction de l'ordre de 60 nm. Les recuits sont du type recuit thermique rapide et/ou au four. Le traitement thermique (30 s, 1000°C) est plus léger que pour les transistors MOS qui ne sont donc pas affectés.

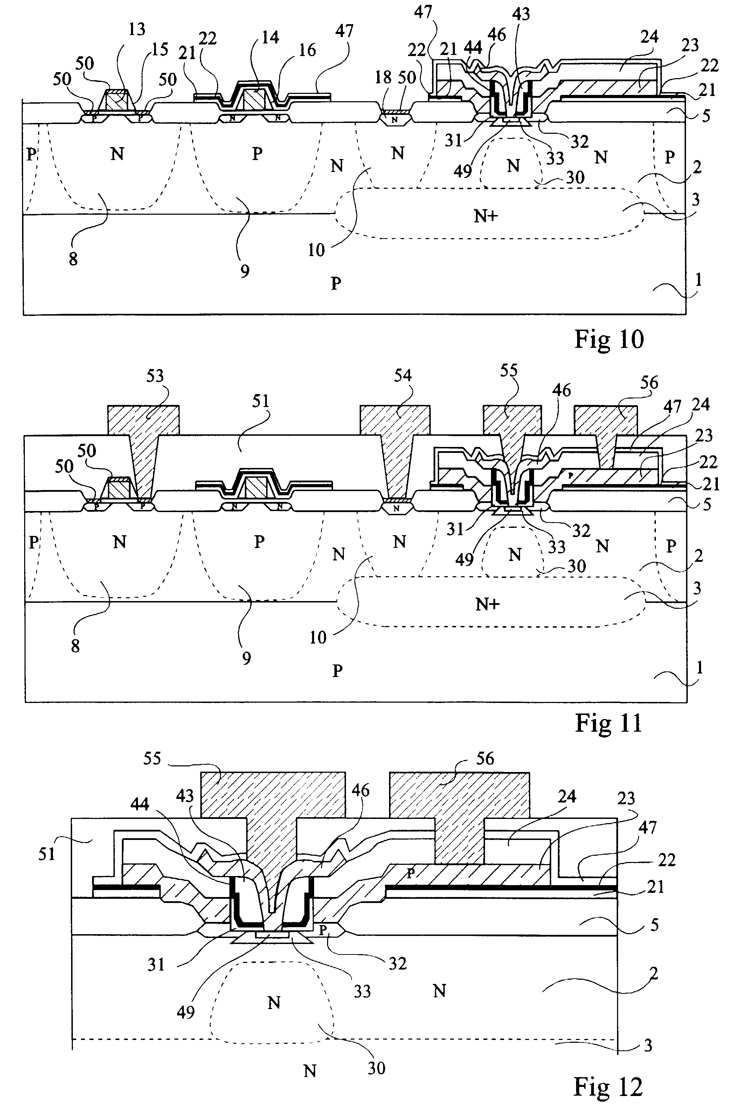

A l'étape illustrée en figure 10, on élimine les couches d'oxyde de silicium d'encapsulation 47, de nitrure de silicium 22 et d'oxyde de silicium de protection 21 au-dessus des zones actives et/ou de silicium polycristallin que l'on souhaite siliciurer, par exemple le transistor MOS à canal P et le puits collecteur du transistor bipolaire. Un siliciure métallique 50 est formé sélectivement au-dessus des régions exposées de silicium mono et polycristallin.

A l'étape illustrée en figure 11, on procède au dépôt d'une couche isolante de planarisation 51 par tout procédé connu, par exemple par dépôt d'une couche de verre dopé au bore et au phosphore (BPSG) et recuit, puis on ouvre cette couche et d'éventuelles couches sous-jacentes aux emplacements où l'on veut prendre des contacts. Seuls certains contacts ont été représentés car, comme cela est bien connu, les contacts ne sont pas nécessairement pris directement au-dessus des zones utiles mais éventuellement sur des prolongements transverses de régions conductrices s'étendant à partir de ces zones utiles. Ainsi, en figure 11, on a seulement représenté un contact de drain 53 d'un transistor MOS à canal P, un contact de collecteur 54, un contact d'émetteur 55 et un contact de base 56 du transistor bipolaire.

La figure 12 correspond au côté bipolaire de la figure 11 et représente la région d'émetteur-base du transistor bipolaire à plus grande échelle.

Dans un mode de réalisation particulier, et pour donner un exemple d'ordres de grandeur, on pourra choisir de réaliser une structure avec les données numériques suivantes (où e désigne une épaisseur, et Cs une concentration superficielle ou une concentration moyenne pour une couche homogène) :

| | |
|---|---|
| substrat 1 | Cs = 10¹⁵ at./cm³, |
| couche épi 2 | Cs = 10¹⁶ at./cm³, e = 0,8 à 1,4 µm, |
| couche enterrée 3 | Cs = 10²⁰ at./cm³, |
| oxyde 5 | e = 0,5 µm, |
| sources et drains N ou P | Cs = 10²⁰ at./cm³, e = 0,15 µm. |

Le procédé de fabrication décrit ci-dessus, tout en étant parfaitement compatible avec les filières existantes de fabrication de transistors CMOS à haute définition, permet de réaliser un transistor bipolaire dont les régions de collecteur, de base intrinsèque et d'émetteur sont auto-alignées.

Ce transistor bipolaire présente de nombreux avantages. Ses performances ne souffrent pas de la présence des transistors CMOS. Il peut en particulier être utilisé aux radiofréquences (fréquence de coupure supérieure à 40 GHz). La très forte transconductance et le faible bruit du transistor bipolaire le rendent apte à des applications analogiques. En particulier, le contact de base (en silicium polycristallin P⁺) permet une forte réduction de la résistance de base d'où un facteur de bruit RF intéressant. Ainsi, le transistor bipolaire peut être utilisé en lieu et place de certains transistors AsGa avec un coût moindre et la possibilité de l'associer sur une même puce à un circuit CMOS très performant.

La présente invention vise à réaliser, dans un circuit intégré BICMOS fabriqué selon la technologie décrite ci-dessus, un condensateur de forte valeur sans augmenter le nombre d'étapes de fabrication.

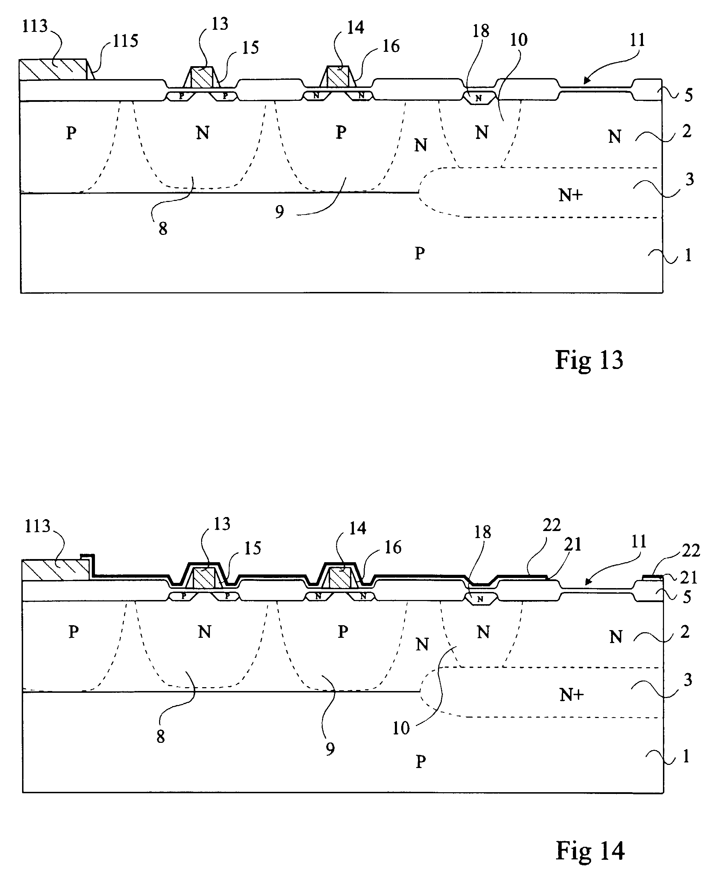

On va décrire la fabrication d'un tel condensateur de forte valeur en relation avec les figures 13 à 19 qui correspondent respectivement aux figures 3 à 9.

Comme le représente la figure 13, à l'étape de la figure 3, en plus des grilles 13 et 14 des transistors MOS, on forme une couche de silicium polycristallin dopé de type P (comme la grille 13 des transistors MOS à canal P, c'est-à-dire, de façon classique par la même implantation que les sources et drains de ces transistors) au-dessus d'une région d'oxyde épais 5. Bien entendu, il se formera sur les bords de cette couche des espaceurs 115 correspondant aux espaceurs 15.

Comme le représente la figure 14, à l'étape de la figure 4, on dépose une double couche d'oxyde et de nitrure de silicium 21-22 que l'on dégage au dessus d'une partie supérieure de la couche 113 en même temps qu'on dégage l'ouverture 11 d'émetteur-base.

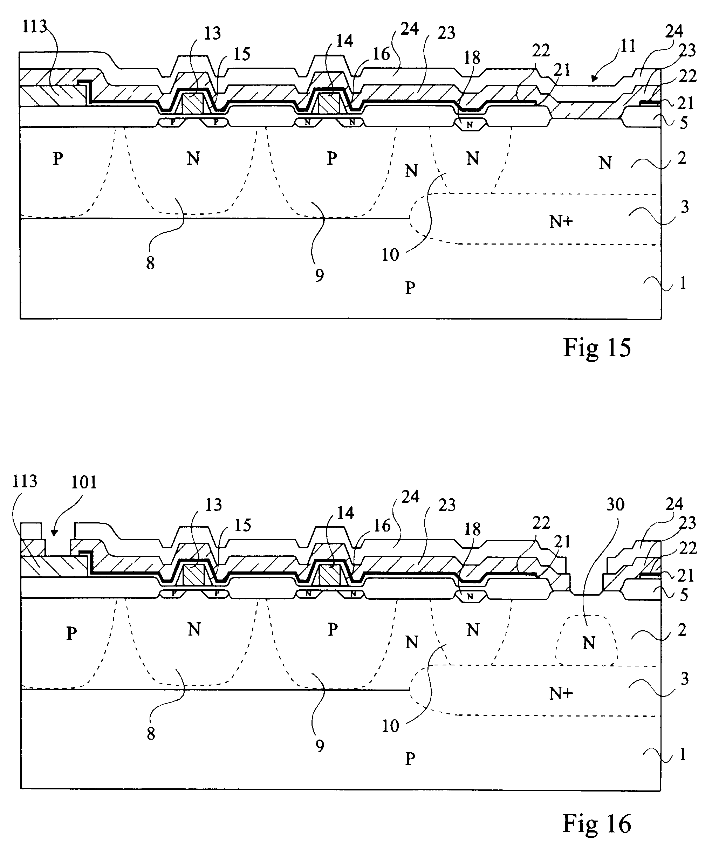

A l'étape de la figure 15, la structure est recouverte des couches de silicium polycristallin de base 23 et d'oxyde de protection 24.

A l'étape de la figure 16, on grave les couches 23 et 24 au-dessus de la région de silicium polycristallin 113 pour former une ouverture 101 en même temps que l'on forme l'ouverture d'émetteur-base.

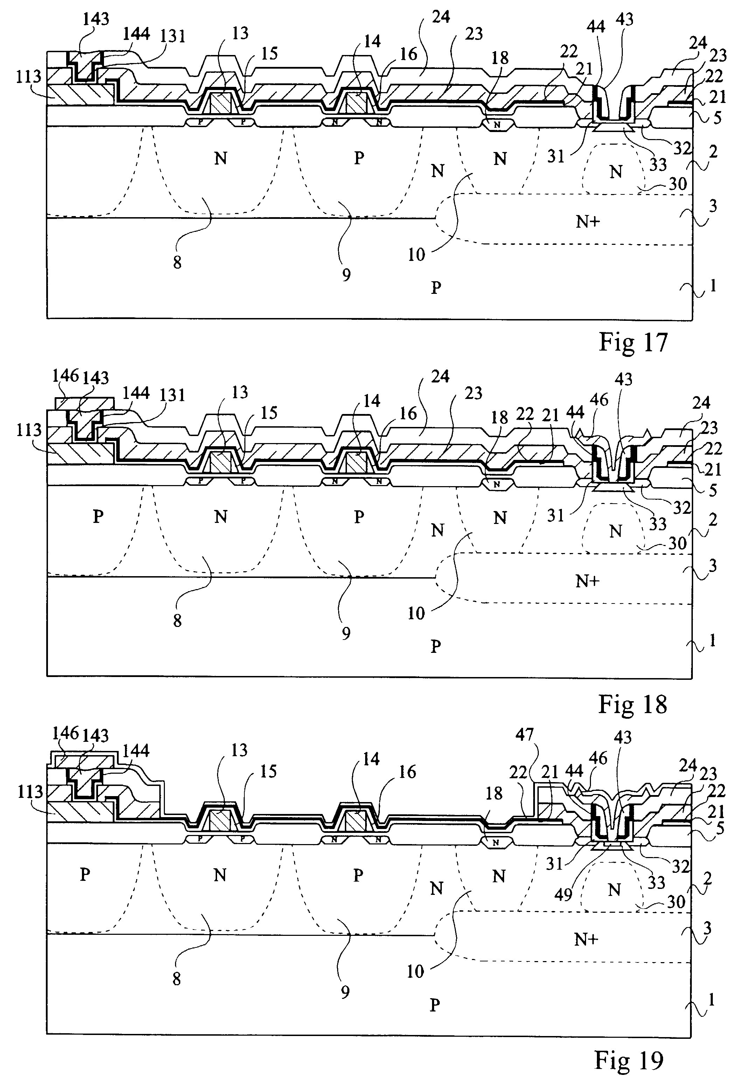

Comme le représente la figure 17, à l'étape de la figure 7, on procède à une oxydation thermique et à un dépôt de nitrure de façon à former au fond et sur les bords de l'ouverture 101 un revêtement comprenant une couche d'oxyde thermique 131 correspondant à la couche 31 et une couche de nitrure de silicium 144 correspondant à la région de nitrure de silicium 44. On procède ensuite au dépôt d'une couche de silicium polycristallin destinée à former après gravure les espaceurs 43.

La largeur de l'ouverture 101 est choisie de façon que, après gravure du silicium polycristallin, cette ouverture reste complètement remplie par du silicium polycristallin 143. Ceci signifie que, si l'on avait prévu la structure pour que les espaceurs aient une largeur de l'ordre de 150 à 200 nm, l'ouverture 101 aura une largeur maximum de l'ordre de 350 nm. En outre, on a décrit précédemment que les espaceurs 43 étaient formés en silicium polycristallin non dopé. Ici, on choisira de réaliser ces espaceurs en silicium polycristallin fortement dopé de type N⁺. Ceci n'affecte pas le fonctionnement de la structure du côté de la région d'émetteur-base puisque le niveau de dopage de type N de la région 43 était, en pratique, indifférent.

A l'étape suivante illustrée en figure 18, on dépose et on grave la couche de silicium polycristallin d'émetteur dopé de type N pour obtenir une région 146 correspondant à la région 46. La région 146 recouvre notamment la région 143.

On obtient ainsi un condensateur dont une première électrode correspond aux régions 143-146, constituées de silicium polycristallin de type N⁺ et dont une deuxième électrode correspond aux régions 113-123 constituées de silicium polycristallin dopé de type P⁺. Ces électrodes sont séparées par une couche d'oxyde mince 131, qui a une épaisseur de l'ordre de 5 à 10 nm et par la couche de nitrure de silicium 144 qui a une épaisseur de l'ordre de 30 nm.

Le procédé se poursuit ensuite sans étape particulière du côté de la région de condensateur sauf bien entendu la réalisation de contacts vers chacune des électrodes.

On obtient ainsi des condensateurs de très forte capacité par unité de surface étant donné que la capacité est réalisée d'une part par des électrodes en regard horizontalement et d'autre part par des électrodes en regard verticalement et périphériquement et du fait que le nitrure a une forte constante diélectrique par rapport à l'oxyde. La capacité par unité de surface peut être ajustée en choisissant l'épaisseur de l'oxyde 131 et l'épaisseur du nitrure 144. Ce procédé ne permet de réaliser que des condensateurs de très petite dimension puisqu'il faut que les espaceurs en silicium polycristallin bouchent complètement les ouvertures 101. Ceci constitue en fait un avantage car, en pratique, on réalisera côte à côte un très grand nombre de condensateurs identiques et on pourra les assembler de diverses façons pour obtenir des condensateurs globaux de valeurs identiques avec un même rapport périmètre/surface. On pourra également former des réseaux de condensateurs.

Il faut souligner à nouveau que la fabrication de ces condensateurs n'implique aucune étape de fabrication supplémentaire par rapport aux étapes préexistantes de la filière de fabrication d'un circuit intégré BICMOS décrite précédemment. Il suffira de modifier l'allure des masques utilisés lors des diverses étapes.

L'homme de l'art notera que d'autres composants peuvent être imaginés en utilisant la filière selon la présente invention et que celle-ci est susceptible de diverses variantes et modifications. Notamment, les diverses valeurs numériques indiquées l'ont été uniquement à titre d'exemple et chaque matériau indiqué à titre d'exemple pourra être remplacé par un autre matériau ayant la même fonction (par exemple sélectivité de gravure par rapport à d'autres matériaux). De plus, divers composants élémentaires pourront être réalisés avec ou sans couche enterrée de l'un ou l'autre type de conductivité.

## Revendications

1. Procédé de fabrication d'un condensateur dans une technologie de fabrication de circuit intégré BICMOS comprenant les étapes suivantes :
déposer, sur une région d'oxyde épais (5), une couche de silicium polycristallin (113) correspondant à une électrode de grille de transistor MOS,
déposer successivement une couche de silicium polycristallin de base (23) et une couche d'oxyde de silicium (24),
former une ouverture (101) dans ces deux dernières couches,
procéder à un recuit thermique en atmosphère oxydante, pour former une couche d'oxyde (131),
déposer une couche de nitrure de silicium (144) et une couche de silicium polycristallin d'espaceur (143), la largeur de l'ouverture (101) étant suffisamment faible pour que, après gravure, le silicium polycristallin d'espaceur remplisse complètement l'ouverture,
déposer une couche de silicium polycristallin d'émetteur (146), et
prendre un contact avec la couche de silicium polycristallin de base et un contact avec la couche de silicium polycristallin d'émetteur.

2. Procédé selon la revendication 1, caractérisé en ce que la couche d'oxyde thermique (131) a une épaisseur de l'ordre de 10 nm.

3. Procédé selon la revendication 1, caractérisé en ce que la couche de nitrure de silicium (144) a une épaisseur de l'ordre de 30 nm.

4. Procédé selon la revendication 1, caractérisé en ce que les couches de silicium polycristallin de grille et de base sont dopées de type P et les couches de silicium polycristallin d'espaceur et d'émetteur sont dopées de type N.
